(19) Europäisches Patentamt / European Patent Office / Office européen des brevets

(11) **EP 3 839 423 A1**

(12) **EUROPEAN PATENT APPLICATION**
published in accordance with Art. 153(4) EPC

(43) Date of publication:
**23.06.2021 Bulletin 2021/25**

(51) Int Cl.:
**G01B 21/22** (2006.01)   **G06F 1/16** (2006.01)

(21) Application number: **18930504.8**

(22) Date of filing: **17.08.2018**

(86) International application number:
**PCT/CN2018/101098**

(87) International publication number:
**WO 2020/034201 (20.02.2020 Gazette 2020/08)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
**KH MA MD TN**

(71) Applicant: **Shenzhen Royole Technologies Co., Ltd**
**Shenzhen, Guangdong 518172 (CN)**

(72) Inventor: **XIE, Jun**
**Shenzhen, Guangdong 518172 (CN)**

(74) Representative: **Mewburn Ellis LLP**
**Aurora Building**
**Counterslip**
**Bristol BS1 6BX (GB)**

(54) **ELECTRONIC DEVICE AND BENDING ANGLE CALCULATION METHOD**

(57)   An electronic device (100) is provided in this disclose, including at least two measuring components (12) and a processor (17). The at least two measuring components (12) are provided on different parts of the electronic device (10). Each measuring components (12) includes an accelerometer (123) and a magnetometer (125). The accelerometer (123) is configured for measuring an acceleration of the electronic device (100). The magnetometer (125) is configured for measuring magnetic induction intensity. The processor (17) is configured for calculating a bending angle of the electronic device (100), based on the accelerations measured by the accelerometers (13) or the magnetic induction intensity measured by the magnetometers (125). A method for calculating a bending angle is also provided in this disclose.

FIG. 2

**Description**

TECHNICAL FIELD

The present disclosure relates to a field of electronic technology, more particularly to an electronic device and a method for calculating a bending angle thereof.

BACKGROUND

Folding electronic devices are popular among consumers due to their convenient portability, powerful functionality and entertainment. An angle between two parts of the electronic device that can be rotated relative to each other, that is, a bending angle of the electronic device, is usually measured by a photoelectric encoder. However, a mechanical structure of the photoelectric encoder is large, which is disadvantageous to reduce weight and thickness of the electronic device.

SUMMARY

To solve the above-mentioned problems, an embodiment of the present disclosure provides an electronic device and a method for calculating a bending angle.

An electronic device includes at least two measuring components and a processor. The at least two measuring components are provided on different parts of the electronic device, which are capable of being bent relative to each other. Each measuring component includes an accelerometer and a magnetometer. The accelerometer is configured to measure an acceleration of the electronic device. The magnetometer is configured to measure magnetic induction intensity. The processor is configured to calculate a bending angle of the electronic device, based on the accelerations measured by the accelerometers of the at least two measuring components or the magnetic induction intensity measured by the magnetometers of the at least two measuring components.

A method for calculating a bending angle, at least two measuring components provided on different parts of the electronic device. Each measuring component includes an accelerometer and a magnetometer. The method for calculating a bending angle includes: obtaining accelerations measured by the accelerometers of the at least two measuring components or a magnetic induction intensity measured by the magnetometers of the at least two measuring components; and calculating a bending angle of the electronic device, based on the acceleration measured by the accelerometers of the at least two measuring components or the magnetic induction intensity measured by the magnetometers of the at least two measuring components.

The electronic device and the method for calculating the bending angle are provided in this disclosure. The measuring components are provided on the different parts of the electronic device. According to the accelerations measured by the accelerometers of the measuring components or the magnetic induction intensity measured by the magnetometers of the measuring components, the bending angle can be obtained. It is beneficial to simplify a structure of the electronic device, and reduce thickness of the electronic device.

BRIEF DESCRIPTION OF THE DRAWINGS

In order to more clearly illustrate the technical solutions of the present disclosure, the accompanying drawings required for describing the embodiments will be briefly described below. Apparently, the accompanying drawings in the following description are merely the some embodiments of the present disclosure, and other drawings may be obtained by those skilled in the art according to these accompanying drawings without paying any creative labor.

FIG. 1 is a schematic structural diagram of an electronic device according to an embodiment of the present disclosure.
FIG. 2 is a schematic diagram of measuring components provided on a flexible screen of the electronic device according to an embodiment of the present disclosure.
FIG. 3 is a schematic side view of the flexible screen according to an embodiment of the present disclosure.
FIG. 4 is a flowchart of a method for calculating a bending angle according to an embodiment of the present disclosure.
FIG. 5 is a flowchart of a method for calculating a bending angle according to another embodiment of the present disclosure.

DETAILED DESCRIPTION

The technical solutions in the embodiments of the present disclosure will be clearly and completely described below with reference to the accompanying drawings in the embodiments of the present disclosure. Apparently, the described embodiments are merely some but not all of the embodiments of the present disclosure. Based on the embodiments of the present disclosure, all other embodiments obtained by a person of ordinary skill in the art without creative efforts shall fall within the protection scope of the present disclosure.

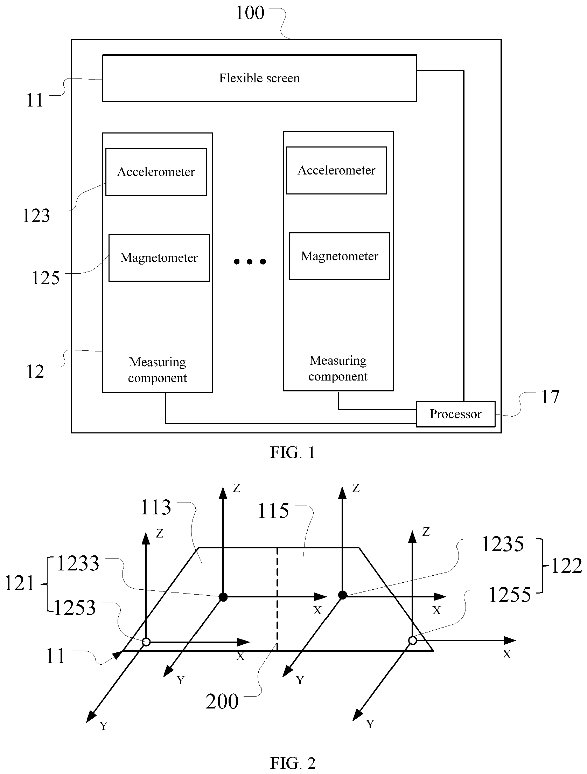

Referring to FIG.1, an electronic device 100 is provided by an embodiment of the present disclosure. The electronic device 100 is a foldable electronic device. The electronic device 100 includes at least two measuring components 12 and a processor 17. The at least two measuring components 12 are provided on different parts of the electronic device 100. Each measuring component 12 includes an accelerometer 123 and a magnetometer 125. The accelerometer 123 is configured to measure an acceleration of the electronic device 100. The magnetometer 125 is configured to measure a magnetic induction intensity. The processor 17 is configured to calculate a bending angle of the electronic device 100, based on the accelerations measured by the accelerometers 123 of the at least two measuring components 12 or the magnetic induction intensity measured by the magnetometers 125 of the at least two measuring components 12.

In the present embodiment, the accelerometer 123 is configured to measure acceleration, where the acceleration measured by the accelerometer 123 is a vector with a magnitude and a direction. The operating principle of the accelerometer 123 is to pre-establish a three-dimensional coordinate system that includes three specified directions that are mutually perpendicular to each other. When the accelerometer 123 is working, acceleration components of the acceleration applied to the accelerometer 123 in three specified directions in the three-dimensional coordinate system can be measured. Then the acceleration may be calculated based on a vector sum of the acceleration components in the three specified directions. In practical applications, considered that the electronic device 100 is usually in a stationary state, the acceleration is approximately equal to the gravitational acceleration g. Even if the electronic device 100 is in a motion state, it usually moves at a uniform speed, rather than performing violent movement. It can be considered that the acceleration is still of the gravitational acceleration. The gravitational acceleration is a vector sum of the acceleration components measured by the accelerometers 123 in the three specified directions. The three specified directions are not absolute directions, but directions determined by the accelerometer 123 used as a benchmark. For example, the X-Y-Z coordinate system includes three specified directions: an X-axis direction, a Y-axis direction and a Z-axis direction. The X-axis direction and the Y-axis direction represent two mutually perpendicular directions on an initial plane where the accelerometer 123 is located, and the Z-axis direction represents a direction perpendicular to the initial plane where the accelerometer 123 is located. When a posture of the accelerometers 123 changes, the X-axis direction, Y-axis direction and Z-axis direction of the accelerometers 123 also change correspondingly. The initial plane can be a horizontal plane, for example, the plane where the accelerometers 123 is located when the electronic device 100 is placed horizontally and the electronic device 100 faces upward.

The accelerometers 123 are positioned the on the electronic device 100, then the acceleration measured by the accelerometer 123 is the acceleration of the electronic device 100. Moreover, there are at least two measuring components 12 located at the electronic device 100. The accelerometer 123 of the at least two measuring components 12 are located at different parts of the electronic device 100. In the case of folding or bending the electronic device 100, the processor 17 calculates the bending angle of the electronic device 100 based on the acceleration components measured by the accelerometers 123 of the at least two measuring components 12.

The magnetometers 125 are located at the electronic device 100. The magnetometers 125 are configured to measure a magnetic induction intensity of the position where the electronic device 100 is located, so that when the accelerometers 13 of the measuring components 12 are failed, according to the magnetic induction intensity, the processor 17 calculates the bending angle of a flexible screen 11. The magnetic induction intensity is a vector with a magnitude and a direction. In the present embodiment, the magnetic induction intensity measured by the magnetometer 125 is a magnetic induction intensity of geomagnetic field at the location where the magnetometer 125 positions. The direction of the geomagnetic field is approximately parallel to the horizontal plane. Similar to the accelerometers 123, the magnetometer 125 pre-establishes a three-dimensional coordinate system. In this embodiment, to facilitate calculation, specified directions of the coordinate system of the magnetometer 125 are the same as the specified directions of the accelerometers 123. In addition, the magnetometers 125 of the at least two measuring components 12 are positioned on two different parts of the electronic device 100. When folding or bending the electronic device 100, the bending angle of the electronic device 100 can be calculated based on the magnetic induction intensity measured by the magnetometers 125 of the at least two measuring components 12.

In detail, please referring to FIG.2, the electronic device 100 has a folding shaft 200. The electronic device 100 further includes a flexible screen 11. In order to achieve folding or bending the electronic device 100, the flexible screen 11 includes a first part 113 and a second part 115, which can be rotated relative to the folding shaft 200. The Y-axis is parallel to the folding shaft 200. The X-axis and the Y-axis are perpendicular to the folding shaft 200. The at least two measuring components 12 include a first measuring component 121 and a second measuring component 122. The first measuring component 121 is positioned on the first part 113. The second measuring component 122 is positioned on the second part 115. Wherein the first measuring component 121 includes a first accelerometer 1233 and a first magnetometer 1253. The second measuring component 122 includes a second accelerometer 1235 and a second magnetometer 1255. The bending angle of the electronic device 100 is a bending angle of the flexible screen 11. The bending angle of the electronic device 100 is considered as an angle defined between the first part 113 and the second part 115.

In the present embodiment, in order to ensure that when folding the flexible screen 11, the first accelerometer 1233, the first magnetometer 1253, the second accelerometer 1235, and the second magnetometer 1255 move together with the fold of the electronic device 100, the first accelerometer 1233, the first magnetometer 1253, the second accelerometer 1235, and the second magnetometer 1255 are fixed on different positions of an inner side of the flexible screen 11 to keep the screen out from covering, and ensure the accuracy of the measurement.

The acceleration components of the first part 113 measured by the first accelerometer 1233 and the acceleration components of the second part 115 measured by the second accelerometer 1235, are sent to the processor 17. According to the acceleration components of the first part 113 measured by the first accelerometer 1233 and the acceleration component of the second part 115 measured by the second accelerometer 1235, the processor 17 determines whether the first accelerometer 1233 and the second accelerometer 1235 are failed. The failed is that when the folding shaft 200 is perpendicular to the horizontal plane, the acceleration components measured by the first accelerometer 1233 and the second accelerometer 1235 are failed for calculating the bending angle of the electronic device 100. Furthermore, when the folding shaft 200 is perpendicular to the horizontal plane, the acceleration components measured by the first accelerometer 1233 and the second accelerometer 1235 in the Y-axis are approximate to the gravitational acceleration, the processor 17 cannot calculate the bending angel between the first part 113 and the second part 115, based on the acceleration components measured by the first accelerometer 1233 and the second accelerometer 1235. The processor 17 determines that the first accelerometer 1233 and the second accelerometer 1235 are failed. If the processor 17 can calculate the bending angle between the first part 113 and the second part 115 according to the acceleration components measured by the first accelerometer 1233 and the second accelerometer 1235, the processor 17 determines that the first accelerometer 1233 and the second accelerometer 1235 are not failed.

In the case of the first accelerometer 1233 of the first measuring component 121 and the second accelerometer 1235 of the second measuring component 122 being failed, the processor 17 controls first magnetometer 1253 and the second magnetometer 1255 to measure the magnetic induction intensity. The magnetic induction intensity measured by the first magnetometer 1253 and the second magnetometer 1255 will be sent to the processor 17. The angle between the first part 113 and the second part 115 is calculated by the processor 17 to obtain the bending angle of the flexible screen 11, based on the magnetic induction intensity components measured by the first magnetometer 1253 and the second magnetometer 1255.

In the case of the processor 17 determining that the first accelerometer 1233 and the second accelerometer 1235 being not failed, in other words, the folding shaft 200 of the electronic device 100 being not perpendicular to the horizontal plane, the bending angle of the flexible screen 11 is calculated by the processor 17, based on the acceleration components measured by the first accelerometer 1233 in the X-axis direction, the Y-axis direction, and the Z-axis direction, and the acceleration components measured by the second accelerometer 1235 in the X-axis direction, the Y-axis direction, and the Z-axis direction.

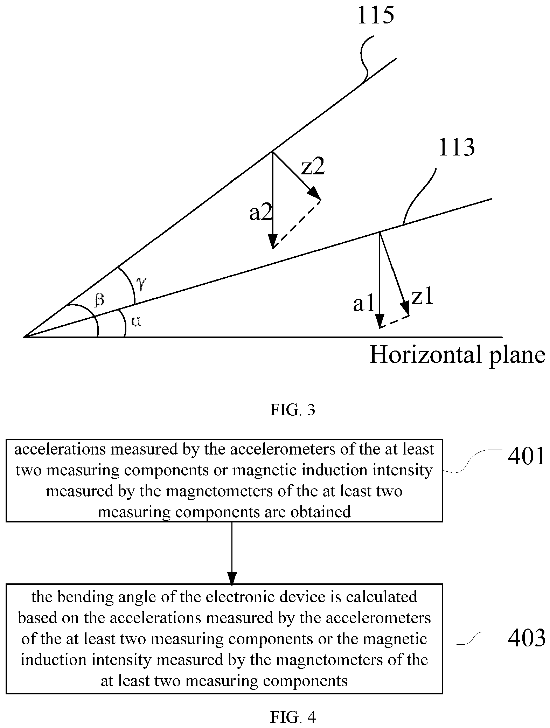

Please referring to FIG.3, a first acceleration a1 represents the acceleration of the first part 113 measured by the first accelerometer 1233, a second acceleration a2 represents the acceleration of the second part 115 measured by the second accelerometer 1235, an acceleration component of the first acceleration a1 in the X-axis is x1, an acceleration component of the first acceleration a1 in the Y-axis is y1, and an acceleration component of the first acceleration a1 in the Z-axis is z1, then $a1 = \sqrt{x1^2 + y1^2 + z1^2}$. Wherein, an acceleration component of the second acceleration a2 in the X-axis is x2, an acceleration component of the second acceleration a2 in the Y-axis is y2, and an acceleration component of the second acceleration a3 in the Z-axis is z2, then $a2 = \sqrt{x2^2 + y2^2 + z2^2}$.

An angle between the first accelerometer 1233 and the second accelerometer 1235 can represent the bending angle $\gamma$ of the flexible screen 11.

Because of $\beta = \arccos\left(\frac{z2}{a2}\right)$ and $\alpha = \arccos\left(\frac{z1}{a1}\right)$, then

$$\gamma = |\beta - \alpha| = \left|\arccos\left(\frac{Z2}{\sqrt{x2^2 + y2^2 + z2^2}}\right) - \arccos\left(\frac{Z1}{\sqrt{x1^2 + y1^2 + z1^2}}\right)\right| (1).$$

That is, the bending angle $\gamma$ of the flexible screen 11 can be calculated by the processor 17 using the formula (1).

In practical applications, considered that the electronic device 100 is usually in a stationary state, the acceleration is approximately equal to the gravitational acceleration g. Even if the electronic device 100 is in a motion state, it usually moves at a uniform speed rather than performing violent movement. It can be considered that the acceleration is still of the gravitational acceleration. In order to reduce the amount of calculation, the processor 17 does not need to calculate the acceleration of each accelerometer, and the acceleration of the accelerometer is considered as g by default. That is, in the case of the processor 17 determining that the first accelerometer 1233 and the second accelerometer 1235 are not failed, the processor 17 calculates the bending angle of the flexible screen 11 based on the acceleration components in the Z-axis direction measured by the first accelerometer 1233 and the second accelerometer 1235.

Therefore, the first accelerometer 1233 and the second accelerometer 1235 only need to send the measured acceleration components in the Z-axis direction to the processor 17. According to the acceleration components in the Z-axis direction measured by the first accelerometer 1233 and the second accelerometer 1235, the processor 17 obtains the bending angle of the flexible screen 11 by using a formula (2).

$$\gamma = |\arccos(z2/g) - \arccos(z1/g)| \qquad (2).$$

However, when the folding shaft 200 is perpendicular to the horizontal plane, the absolute values of the acceleration components of the first acceleration a1 and the acceleration component of the second acceleration a2 in the Y-axis may be approximately equal to gravitational acceleration, the absolute value of the corresponding acceleration component of the first acceleration a1 and the second acceleration a2 in the X-axis and the Z-axis are approximately equal to zero. In other words, the processor 17 cannot obtain the angle $\gamma$ based on the accelerations measured by the first accelerometer 1233 and the second accelerometer 1235. Then the processor 17 determines that the first accelerometer 1233 and the second accelerometer 1235 are failed.

The processor 17 compares the absolute values of the acceleration components measured by the first accelerometer 1233 and the second accelerometer 1235 in the Y-axis direction with a preset threshold value. In the present embodiment, the preset threshold value is set to be 9.8. The preset threshold value is a parameter which can be adjusted. The preset threshold value is usually slightly less than gravitational acceleration.

If both the absolute values of the acceleration components measured by the first accelerometer 1233 and the second accelerometer 1235 in the Y-axis direction are greater than the preset threshold value, the processor 17 determines that the folding shaft 200 is perpendicular to the horizontal plane. In other words, the processor 17 determines that the first accelerometer 1233 and the second accelerometer 1235 are failed. The processor 17 calculates the bending angle of the flexible screen 11, based on the magnetic induction intensity components measured by the first magnetometer 1253 and the second magnetometer 1255.

In the case of the processor 17 determining that the first accelerometer 1233 and the second accelerometer 1235 are failed, a first magnetic induction intensity b1 is measured by the first magnetometer 1253, where the acceleration component in the X-axis is x3, the acceleration component in the Y-axis is y3, the acceleration component in the Z-axis is z3. A second magnetic induction intensity b2 is measured by the second magnetometer 1255, where the acceleration component in the X-axis is x4, the acceleration component in the Y-axis is y4, and the acceleration component in the Z-axis is z4. A bending angle $\gamma$ of the flexible screen 11 can be represented as an angle between the first magnetometer 1253 and the second magnetometer 1255:

$$\gamma = \left| \arccos\left(\frac{z4}{\sqrt{x4^2+y4^2+z4^2}}\right) - \arccos\left(\frac{z3}{\sqrt{x3^2+y3^2+z3^2}}\right) \right| \qquad (3).$$

The bending angle $\gamma$ can be calculated by the processor 17 using the formula (3), when the folding shaft 200 is perpendicular to the horizontal plane.

Where the processor 17 is used for performing calculations, the processor 17 can be a central processing unit of the electronic device 100, or a sensor hub configured for the electronic device 100, or other control units being capable of computing, which is not limited in the present disclosure.

After the bending angle has been calculated by the processor 17, some control operations may be performed based on the current bending angle of the flexible screen 11, such as controlling to activate and deactivate the flexible screen 11 or controlling the flexible screen 11 to display specific contents, etc. The embodiment of the present disclosure does not limit the control operation.

In one embodiment, the first magnetometer 1253 and the second magnetometer 1255 are initially turned off. The first magnetometer 1253 and the second magnetometer 1255 are controlled to start by the processor 17 to measure the magnetic induction intensity, when the processor 17 determines that the first magnetometer 1253 and the second magnetometer 1255 are failed.

The present embodiment provides a way to calculate the bending angle of the electronic device 100. The measuring components 12 are located at the different positions of the electronic device 100. According to the accelerations measured by the accelerometers 123 of the measuring components 12 or the magnetic induction intensity measured by the magnetometers 125 of the measuring components 12, the bending angle can be obtained. It is beneficial to simplify a structure of the electronic device 100, and reduce thickness of the electronic device 100.

In addition, in the case that the accelerometers 123 are not failed, the accelerometers 123 of the at least two measuring components 12 measure the accelerations. The bending angle of the flexible screen 11 can be calculated by the processor 17, based on the measured accelerations. It is easy to perform the control operations based on the bending angle. In the case that the accelerometers 123 are failed, the magnetometers 125 of at least two the measuring components 12 measure the magnetic induction intensity to determine the bending angle of the flexible screen 11. That is, the electronic device 100 uses the accelerometers 123 as a main measurement means, and uses the magnetometers 125 as an auxiliary means to obtain the bending angle of the flexible screen 11.

In one embodiment, after the bending angle of the flexible screen 11 has been calculated, the processor 17 is also configured for adjusting color temperature, brightness, color, and the like of the flexible screen 11, to provide the best display effect and users experience.

In one embodiment, operating modes of the electronic device 100 can be adjusted by the processor 17, based on the bending angle of the flexible screen 11. For example, when the bending angle is 0 degree, in other words, the first part 113 and the second part 115 of the electronic device 100 are folded together, the electronic device 100 can be switched from a first operation mode to a second operation mode by the processor 17. The first operation mode is a normal working mode. The second operation mode is a sleep mode. It can be understood that, the first mode is not limited to the normal working mode, and the second mode is not limited to the sleep mode, which can be set as required.

In another embodiment, when the flexible screen 11 is bent, the acceleration components measured by the accelerometers 123 of the at least two measuring components 12 in the specified directions are different. The bending angle of the flexible screen 11 can be calculated based on the acceleration components detected. Similarly, the magnetic induction intensity components measured by the magnetometers 125 of the at least two measuring components 12 in the specified directions are different. The bending angle of the flexible screen 11 can be calculated by the processor 17, based on the magnetic induction intensity components detected.

Therefore, the accelerometers 123 of the at least two measuring components 12 measure the acceleration components in any one or some specified directions, the bending angle of the flexible screen 11 can be calculated by the processor 17 based on the acceleration components measured by the accelerometers 123 of the at least two measuring components 12. The magnetometers 125 of the at least two measuring components 12 measure the magnetic induction intensity components in any one or some specified directions. The bending angle of the flexible screen 11 also can be calculated by the processor 17, based on the magnetic induction intensity components measured by the magnetometers 125 of the at least two measuring components 12.

It is only illustrated in the above embodiments that the electronic device 100 includes two measuring components 12. In fact, when the electronic device 100 includes more than two measuring components 12, the method for calculating the bending angle is similar to the method described above. For example, a bending angle between each two adjacent parts of the electronic device 100 can be calculated firstly by the processor 17, and an average value can be obtained for all the bending angles by the processor 17.

In application, the processor 17 can obtain multiple bending angles at different time, and calculate the bending speed of the flexible screen 11 based on the changes in the bending angle.

It should be noted that the electronic device 100 provided in the above embodiments is only illustrated by taking the division of above described functional blocks as an example. In practice, the functional assignment may be performed by different functional modules as required, i.e. the internal structure of the electronic device 100 is divided into different functional modules to perform all or part of the functions described above. In addition, the electronic device 100 provided in the above embodiments follows the same concept as the method embodiments of calculating the bending angle, therefore the detailed implementation of the electronic device can be seen in detail in the method embodiments, and will not be described redundantly.

In an alternative embodiment, the electronic device 100 may further includes other necessary or unnecessary structures or modules, for instance, one or more of the following components: a processing component, a memory, a sensor component, a communication component, a power component, a multimedia component, an audio component, an input/output (I/O) interface. The processing component typically controls overall operations of the electronic device 100, such as the operations associated with display, telephone calls, data communications, camera operations, and recording operations. The processing component may include one or more processors to execute instructions to perform all or part of the steps in the above described methods. The memory is used for storing various types of data to support the operation of the electronic device 100.Examples of such data may include instructions for any applications or methods operated on the electronic device 100, contact data, phonebook data, messages, pictures, video, etc. The memory may be implemented using any type of volatile or non-volatile memory devices, or a combination thereof, such as a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, a magnetic or optical disk. The electronic device 100 can access a wireless network based on a communication standard, such as WiFi, 2G, or 3G, or a combination thereof. The sensor component, the power component, and other functional modules are not described here for concise.

Referring to FIG. 4, a method for calculating a bending angle is provided in the present embodiment. The at least two components 12 are provided on different parts of the electronic device 100. Each of the at least two measuring components 12 includes one accelerometer 123 and one magnetometer 125. The method for calculating the bending angle includes the following steps.

Step 401, accelerations measured by the accelerometers 123 of the at least two measuring components 12 or magnetic induction intensity measured by the magnetometers 125 of the at least two measuring components 12 are obtained.

Step 403, the bending angle of the electronic device 100 is calculated based on the accelerations measured by the accelerometers 123 of the at least two measuring components 12 or the magnetic induction intensity measured by the magnetometers 125 of the at least two measuring components 12.

Furthermore, the at least two measuring components 12 include the first measuring component 121 and the second measuring component 122. The first measuring component 121 includes the first accelerometer 1233 and the first magnetometer 1253. The second measuring component 122 includes the second accelerometer 1235 and the second magnetometer 1253. The electronic device 100 has the folding shaft 200. The electronic device 100 further includes the first part 113 and the second part 115. The first part 113 and the second part 115 are capable of rotating relative to the folding shaft 200. The first accelerometer 1233 and the first magnetometer 1253 are located at the first part 113. The second accelerometer 1235 and the second magnetometer 1255 are located at the second part 115. In the illustrated embodiment, the electronic device 100 further includes the flexible screen 11. The flexible screen 11 includes the first part 113 and the second part 115. In an alternative embodiment, the electronic device 100 can be other foldable electronic devices in other types, such as laptops.

The step 401, accelerations measured by the accelerometers 123 of the at least two measuring components 12 or magnetic induction intensity measured by the magnetometers 125 of the at least two measuring components 12 being obtained, includes: the accelerations measured by the first accelerometer 1233 and the second accelerometer 1235, or the magnetic induction intensity measured by the first magnetometer 1253 and the second magnetometer 1255 are obtained.

The step 403, the bending angle of the electronic device 100 being calculated based on the accelerations measured by the accelerometers 123 of the at least two measuring components 12 or the magnetic induction intensity measured by the magnetometers 125 of the at least two measuring components 12, includes: the bending angle of the electronic device 100 is calculated based on the accelerations measured by the first accelerometer 1233 and the second accelerometer 1235, or the magnetic induction intensity measured by the first magnetometer 1253 and the second magnetometer 1255.

The step 403 specifically includes: determining whether the first accelerometer 1233 and the second accelerometer 1235 are failed based on the accelerations measured by the first accelerometer 1233 and the second accelerometer 1235. The first accelerometer 1233 and the second accelerometer 1235 are failed when the folding shaft 200 is perpendicular to the horizontal plane. If the first accelerometer 1233 and the second accelerometer 1235 are not failed, the bending angle of the electronic device 100 is calculated, based on the accelerations measured by the first accelerometer 1233 and the second accelerometer 1235. If the first accelerometer 1233 and the second accelerometer 1235 are failed, the bending angle of the electronic device 100 is calculated, based on the magnetic induction intensity measured by the first magnetometer 1253 and the second magnetometer 1255.

In one embodiment, the accelerations measured by the first accelerometer 1233 and the second accelerometer 1235, includes: the first accelerometer 1233 and the second magnetometer 1235 are used to measure acceleration components in the specified directions. The specified directions include the X-axis direction, the Y-axis direction, and the Z-axis direction. Both the X-axis direction and the Z-axis direction are perpendicular to the folding shaft 200, and the Y-axis direction is parallel to the folding shaft 200.It is determined whether the first accelerometer 1233 and the second accelerometer 1235 are failed based on the accelerations measured by the first accelerometer 1233 and the second accelerometer, 1235 includes: absolute values of the acceleration components measured by the first accelerometer 1233 and the second accelerometer 1235 in the Y-axis direction with a preset threshold value are compared, if both a absolute value of the acceleration component measured by the first accelerometer 1233 and a absolute value of the acceleration component measured by the second accelerometer 1235 being greater than the preset threshold value, it is determined that the folding shaft 200 is perpendicular to the horizontal plane, then the first accelerometer 1233 and the second accelerometer 1235 are failed.

In one embodiment, if the first accelerometer 1233 and the second accelerometer 1235 are not failed, the bending angle of the electronic device 100 being calculated, based on the accelerations measured by the first accelerometer 1233 and the second accelerometer 1235, includes: according to the acceleration components measured by the first accelerometer 1233 and the second accelerometer 1235, the bending angle of the electronic device 100 is calculated by using a following formula.

$$\gamma = \left| \arccos\left(\frac{Z2}{\sqrt{x2^2+y2^2+z2^2}}\right) - \arccos\left(\frac{Z1}{\sqrt{x1^2+y1^2+z1^2}}\right) \right|.$$

Wherein $\gamma$ represents the bending angle of the electronic device, x1, y1, z1 each represents a corresponding acceleration component in the X-axis direction, the Y-axis direction, and the Z-axis direction measured by the first accelerometer1233,x2, y2, z2 each represents a corresponding acceleration component in the X-axis direction, the Y-axis direction, and the Z-axis direction measured by the second accelerometer 1235.

In one embodiment, if the first accelerometer and the second accelerometer are not failed, the bending angle of the electronic device being calculated, based on the accelerations measured by the first accelerometer and the second accelerometer, includes: according to the acceleration components measured by the first accelerometer 1233 and the second accelerometer 1235, the bending angle of the electronic device 100 is calculated by using a following formula:

$$\gamma = |\arccos(z2/g)-\arccos(z1/g)|.$$

Wherein $\gamma$ represents the bending angle of the electronic device, z1 represents the acceleration component in the Z-axis direction measured by the first accelerometer, z2 represents the acceleration component in the Z-axis direction measured by the second accelerometer, and g represents gravitational acceleration.

In one alternative embodiment, if the first accelerometer 1233 and the second accelerometer 1235 are failed, the bending angle of the electronic device 100 is calculated, based on the magnetic induction intensity measured by the first magnetometer 1253 and the second magnetometer 1255, includes: the first magnetometer 1253 and the second magnetometer 1255 are used for detecting magnetic induction intensity components in specified direction, the specified directions include the X-axis direction, the Y-axis direction, and the Z-axis direction, in the case that the first accelerometer 1233 and the second accelerometer 1235 are failed, according to the magnetic induction intensity components measured by the first magnetometer 1253 in the X-axis direction, the Y-axis direction and the Z-axis direction, and the magnetic induction intensity components measured by the second magnetometer 1255 in the X-axis direction, the Y-axis direction, and the Z-axis direction, the bending angle of the electronic device 100 is calculated by using a following formula:

$$\gamma = \left| \arccos\left(\frac{Z4}{\sqrt{x4^2+y4^2+z4^2}}\right) - \arccos\left(\frac{Z3}{\sqrt{x3^2+y3^2+z3^2}}\right) \right|.$$

Wherein $\gamma$ represents the bending angle of the electronic device 100, x3,y3,z3 each represents a corresponding magnetic induction intensity component in the X-axis direction, the Y-axis direction, and the Z-axis direction measured by the first magnetometer, x4,y4,z4 each represents a corresponding magnetic induction intensity component in the X-axis direction, the Y-axis direction, and the Z-axis direction measured by the second magnetometer 1255.

In other embodiments, the step 403 specifically includes: the accelerometers 123 of the at least two measuring components 12 are used to measure accelerations of the electronic device 100; it is determined whether the accelerometers 123 of the at least two measuring components 12 are failed; if the accelerometers 123 of the at least two measuring components 12 are not failed, the bending angle of the electronic device 100 is calculated based on the accelerations measured by the accelerometers 123 of the at least two measuring components 12; if the accelerometers 123 of the at least two measuring components 12 are failed, the bending angle of the electronic device 100 is calculated, based on the magnetic induction intensity measured by the magnetometers 125 of the at least two measuring components 12.

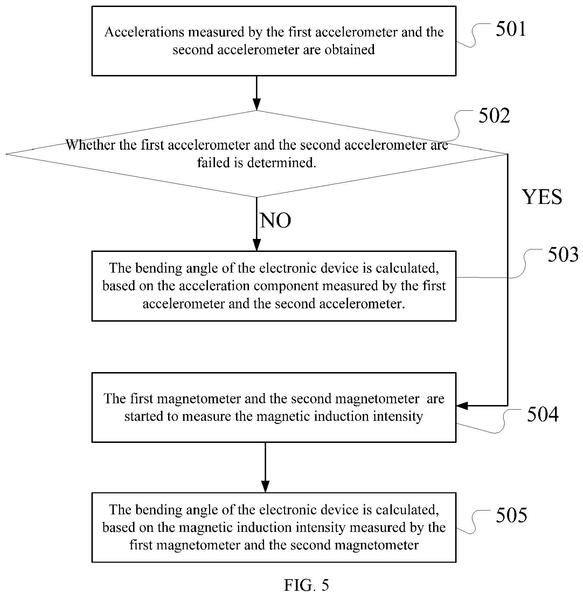

Referring to FIG. 5, a method for calculating a bending angle is provided in another embodiment. The electronic device 100 has the folding shaft 200. The electronic device 100 further includes the first part 113 and the second part 115. The first part 113 and the second part 115 can rotate relative to the folding shaft 200. The first measuring component 121 is positioned on the first part 113. The second measuring component 122 is positioned on the second part 115. The first measuring component 121 includes the first accelerometer 1233 and the first magnetometer 1253. The second measuring component 122 includes the second accelerometer 1235 and the second magnetometer 1255. In the illustrated embodiment, the method for calculating the bending angle is applied in the electronic device 100. The method for calculating the bending angle includes following steps.

Step 501, accelerations measured by the first accelerometer 1233 and the second accelerometer 1235 are obtained.

In detail, the accelerations measured by the first accelerometer 1233 and the second accelerometer 1235 being obtained, includes: by using the first accelerometer 1233 and the second accelerometer 1235 to measure acceleration components in specified directions. The specified directions include the X-axis direction, the Y-axis direction, and the Z-axis direction. Both the X-axis direction and the Z-axis direction are perpendicular to the folding shaft 200, and the Y-axis direction is parallel to the folding shaft 200.

Step 502, whether the first accelerometer 1233 and the second accelerometer 1235 are failed is determined, based on the accelerations measured by the first accelerometer 1233 and the second accelerometer 1235. IF is "NO", in other words, the first accelerometer 1233 and the second accelerometer 1235 are not failed, then step 503 will be executed. IF is "YES", in other words, the first accelerometer 1233 and the second accelerometer 1235 are failed, then step 504 will be executed.

In detail, it be determined whether the first accelerometer 1233 and the second accelerometer 1235 are failed, includes: comparing absolute values of the acceleration components measured by the first accelerometer 1233 and the second accelerometer 1235 in the Y-axis direction with a preset threshold value; if both the absolute value of the acceleration component in the Y-axis direction measured by the first accelerometer 1233 and the absolute value of the acceleration component in the Y-axis direction measured by the second accelerometer 1235 being more than the preset threshold value, determining that the first accelerometer 1233 the second accelerometer 1235 are failed, and determining that the folding shaft 200 is perpendicular to the horizontal plane.

Step 503, the bending angle of the electronic device 100 is calculated, based on the acceleration component measured by the first accelerometer 1233 and the second accelerometer 1235.

The bending angle of the electronic device 100 is calculated, based on the acceleration component measured by the first accelerometer 1233 and the second accelerometer 1235, by using a following formula:

$$\gamma = |\beta - \alpha| = |\arccos(\frac{z2}{\sqrt{x2^2+y2^2+z2^2}}) - \arccos(\frac{z1}{\sqrt{x1^2+y1^2+z1^2}})|.$$

Wherein $\gamma$ represents the bending angle of the electronic device 100, x1, y1, z1 each represents a corresponding acceleration component in the X-axis direction, the Y-axis direction, and the Z-axis direction measured by the first accelerometer 1233, x2, y2, z2 each represents a corresponding acceleration component in the X-axis direction, the Y-axis direction, and the Z-axis direction measured by the second accelerometer 1235.

In one embodiment, the bending angle of the electronic device 100 is calculated, based on the acceleration component measured by the first accelerometer 1233 and the second accelerometer 1235, by using a following formula:

$$\gamma = |\arccos(z2/g) - \arccos(z1/g)|.$$

Wherein $\gamma$ represents the bending angle of the electronic device 100, z1 represents the acceleration component in the Z-axis direction measured by the first accelerometer 1233, z2 represents the acceleration component in the Z-axis direction measured by the second accelerometer 1235.

Step 504, the first magnetometer 1253 and the second magnetometer 1255 are started to measure the magnetic induction intensity.

Step 505, the bending angle of the electronic device 100 is calculated, based on the magnetic induction intensity measured by the first magnetometer 1253 and the second magnetometer 1255.

In detail, the step 505, the bending angle of the electronic device 100 being calculated, based on the magnetic induction intensity measured by the first magnetometer 1253 and the second magnetometer 1255, includes: the first magnetometer 1253 and the second magnetometer 1255 are configured for measuring magnetic induction intensity components in specified directions, the specified directions include the X-axis direction, the Y-axis direction, and the Z-axis direction, if the first accelerometer and the second accelerometer being determined to be failed, according to the magnetic induction intensity components measured by the first magnetometer 1253 and the magnetic induction intensity components measured by the second magnetometer 1255, the bending angle of the electronic device 100 is calculated by using a following formula:

$$\gamma = |\arccos(\frac{z4}{\sqrt{x4^2+y4^2+z4^2}}) - \arccos(\frac{z3}{\sqrt{x3^2+y3^2+z3^2}})|.$$

Wherein $\gamma$ represents the bending angle of the electronic device 100, x3, y3, z3 each represents a corresponding magnetic induction intensity component in the X-axis direction, the Y-axis direction and the Z-axis direction measured by the first magnetometer 1253, x4, y4, z4 each represents a corresponding magnetic induction intensity component in the X-axis direction, the Y-axis direction, and the Z-axis direction measured by the second magnetometer 1255.

If the first magnetometer 1253 and the second magnetometer 1255 have measured the magnetic induction intensity before calculating the bending angle of the electronic device 100, the step 504 can be omitted.

Step 403 shown in Fig. 4 has a certain correlation with step 501-505 shown in FIG.5. The relevant steps shown in Fig. 4 and Fig.5 can be cross-referenced.

The above described embodiments are preferred embodiments of the present disclosure. It should be noted that, persons of ordinary skill in the art, based on the idea of the present disclosure, will have changes in specific implementation manners and application ranges. In summary, the contents of the present specification should not be construed as limiting the present disclosure.

**Claims**

1. An electronic device comprising, at least two measuring components and a processor;

   wherein the at least two measuring components are provided on different parts of the electronic device; the different parts are capable of being bent relative to each other;
   each measuring component comprises an accelerometer and a magnetometer; wherein the accelerometer is configured for measuring an acceleration of the electronic device, the magnetometer is configured for measuring magnetic induction intensity;
   the processor is configured for calculating a bending angle of the electronic device, based on the accelerations measured by the accelerometers of the at least two measuring components or the magnetic induction intensity measured by the magnetometers of the at least two measuring components.

2. The electronic device of claim 1, wherein the at least two measuring components comprise a first measuring component and a second measuring component, the first measuring component comprises a first accelerometer and a first magnetometer, the second measuring component comprises a second accelerometer and a second magnetometer;
   the electronic device has a folding shaft, the electronic device further comprises a first part and a second part, the first part and the second part are capable of rotating relative to the folding shaft;
   the first accelerometer and the first magnetometer are located at the first part, the second accelerometer and the second magnetometer are located at the second part;
   the bending angle is an angle defined between the first part and the second part.

3. The electronic device of claim 2, wherein the "the processor is configured for calculating a bending angle of the electronic device, based on the acceleration measured by the accelerometers of the at least two measuring components and the magnetic induction intensity measured by the magnetometers of the at least two measuring components", comprises:

   the processor is configured to determine whether the first accelerometer and the second accelerometer are failed, wherein the first accelerometer and the second accelerometer are failed when the folding shaft is perpendicular to a horizontal plane, and then the acceleration components measured by the first accelerometer and the second accelerometer are invalidly configured for calculating the bending angle;
   if the processor determines that the first accelerometer and the second accelerometer are not failed, the processor calculates the bending angle, based on the accelerations measured by the first accelerometer and the second accelerometer;
   if the processor determines that the first accelerometer and the second accelerometer are failed, the processor calculates the bending angle, based on the magnetic induction intensity measured by the first magnetometer and the second magnetometer.

4. The electronic device of claim 3, wherein the first accelerometer and the second accelerometer are configured for measuring acceleration components in specified directions; the specified directions comprise an X-axis direction, a Y-axis direction, and a Z-axis direction; both the X-axis direction and the Z-axis direction are perpendicular to the folding shaft, and the Y-axis direction is parallel to the folding shaft;
   "the processor determining whether the first accelerometer and the second accelerometer are failed" comprises:

   the processor is configured to compare absolute values of the acceleration components in the Y-axis direction with a preset threshold value;
   if both the absolute value of the acceleration component in the Y-axis direction measured by the first accelerometer and the absolute value of the acceleration component in the Y-axis direction measured by the second accelerometer are greater than the preset threshold value, the processor determines that the first accelerometer and the second accelerometer are failed, thereby the processor determining that the folding shaft is perpendicular to the horizontal plane.

5. The electronic device of claim 4, wherein the processor calculates the bending angle based on the acceleration components in the X-axis direction, the Y-axis direction, and the Z-axis direction measured by the first accelerometer, and the acceleration components in the X-axis direction, the Y-axis direction, and the Z-axis direction measured by the second accelerometer, when the first accelerometer and the second accelerometer are not failed.

6. The electronic device of claim 5, wherein the bending angle is determined by the processor using a following formula:

$$\gamma = \left| \arccos\left(\frac{z2}{\sqrt{x2^2+y2^2+z2^2}}\right) - \arccos\left(\frac{z1}{\sqrt{x1^2+y1^2+z1^2}}\right) \right| \; ;$$

wherein $\gamma$ represents the bending angle of the electronic device, x1, y1, z1 each represents a corresponding acceleration component in the X-axis direction, the Y-axis direction, and the Z-axis direction measured by the first accelerometer, x2, y2, z2 each represents a corresponding acceleration component in the X-axis direction, the Y-axis direction, and the Z-axis direction measured by the second accelerometer.

7. The electronic device of claim 4, wherein the processor calculates the bending angle based on the acceleration component in the Z-axis direction measured by the first accelerometer and the acceleration component in the Z-axis direction measured by the second accelerometer, when the first accelerometer and the second accelerometer are not failed.

8. The electronic device of claim 7, wherein the bending angle is determined by the processor using a following formula:

$$\gamma = \left| \arccos(z2/g) - \arccos(z1/g) \right| \; ;$$

wherein $\gamma$ represents the bending angle of the electronic device, z1 represents the acceleration component in the Z-axis direction measured by the first accelerometer, z2 represents the acceleration component in the Z-axis direction measured by the second accelerometer, and g represents gravitational acceleration.

9. The electronic device of claim 4, wherein the first magnetometer and the second magnetometer are configured for measuring magnetic induction intensity components in specified directions, the specified directions comprise an X-axis direction, a Y-axis direction, and a Z-axis direction;
the processor calculates the bending angle based on the magnetic induction intensity components in the X-axis direction, the Y-axis direction, and the Z-axis direction measured by the first magnetometer, and the magnetic induction intensity components in the X-axis direction, the Y-axis direction, and the Z-axis direction measured by the second magnetometer, when the processor determines that the folding shaft is perpendicular to a horizontal plane.

10. The electronic device of claim 9, wherein the bending angle is determined by the processor using a following formula:

$$\gamma = \left| \arccos\left(\frac{z4}{\sqrt{x4^2+y4^2+z4^2}}\right) - \arccos\left(\frac{z3}{\sqrt{x3^2+y3^2+z3^2}}\right) \right| \; ;$$

wherein $\gamma$ represents the bending angle of the electronic device, x3, y3, z3 each represents a corresponding magnetic induction intensity component in the X-axis direction, the Y-axis direction, and the Z-axis direction measured by the first magnetometer, x4, y4, z4 each represents a corresponding magnetic induction intensity component in the X-axis direction, the Y-axis direction, and the Z-axis direction measured by the second magnetometer.

11. The electronic device of claim 1, wherein the magnetometer of each of the at least two measuring components is initially out of work;
when the processor determines that the accelerometers of the at least two measuring components are failed, the processor controls the magnetometers of the at least two measuring components to measure the magnetic induction intensity.

12. The electronic device of claim 1, wherein the processor is further configured for controlling and adjusting operating modes of the electronic device.

13. The electronic device of claim 1, wherein the electronic device further comprises a flexible screen; the at least two measuring components are located at different parts of the flexible screen; wherein the bending angle of the electronic device is a bending angle of the flexible screen.

14. A method for calculating a bending angle, at least two measuring components provided on different parts of the electronic device, the different parts being capable of being bent relative to each other, each of the at least two measuring components comprising an accelerometer and a magnetometer, the method for calculating the bending angle comprising:

    obtaining accelerations measured by accelerometers of the at least two measuring components or magnetic induction intensity measured by magnetometers of the at least two measuring components; and
    calculating a bending angle of the electronic device, based on the accelerations measured by the accelerometers of the at least two measuring components or the magnetic induction intensity measured by the magnetometers of the at least two measuring components.

15. The method of claim 14, wherein the at least two measuring components comprise a first measuring component and a second measuring component, the first measuring component comprises a first accelerometer and a first magnetometer, the second measuring component comprises a second accelerometer and a second magnetometer; the electronic device further comprises a folding shaft, the different parts comprises a first part and a second part, the first part and the second part are capable of rotating relative to the folding shaft;
    the first accelerometer and the first magnetometer are located at the first part, the second accelerometer and the second magnetometer are located at the second part;
    the "obtaining accelerations measured by accelerometers of at least two measuring components or magnetic induction intensity measured by magnetometers of the at least two measuring components" comprises: obtaining the accelerations measured by the first accelerometer and the second accelerometer, or the magnetic induction intensity measured by the first magnetometer and the second magnetometer;
    the "calculating a bending angle of the electronic device , based on the accelerations measured by the accelerometers of the at least two measuring components or the magnetic induction intensity measured by the magnetometers of the at least two measuring components" comprises: calculating the bending angle of the electronic device, based on the accelerations measured by the first accelerometer and the second accelerometer, or the magnetic induction intensity measured by the first magnetometer and the second magnetometer.

16. The method of claim 15, wherein the "calculating a bending angle of the electronic device, based on the accelerations measured by the accelerometers of the at least two measuring components or the magnetic induction intensity measured by the magnetometers of the at least two measuring components" comprises:

    determining whether the first accelerometer and the second accelerometer are failed, the first accelerometer and the second accelerometer are failed when the folding shaft is perpendicular to a horizontal plane, and then the acceleration measured by the first accelerometer and the second accelerometer are invalidly used for calculating the bending angle;
    if the first accelerometer and the second accelerometer are not failed, then calculating the bending angle of the electronic device, based on the accelerations measured by the first accelerometer and the second accelerometer;
    if the first accelerometer and the second accelerometer are failed, calculating the bending angle of the electronic device, based on the magnetic induction intensity measured by the first magnetometer and the second magnetometer.

17. The method of claim 16, wherein the "obtaining the accelerations measured by the first accelerometer and the second accelerometer" comprises: using the first accelerometer and the second accelerometer to measure acceleration components in specified directions, the specified directions comprise an X-axis direction, a Y-axis direction, and a Z-axis direction, both the X-axis direction and the Z-axis direction are perpendicular to the folding shaft, and the Y-axis direction is parallel to the folding shaft;
    the "determining whether the first accelerometer and the second accelerometer are failed" comprises:
    comparing absolute values of the acceleration components measured by the first accelerometer and the second accelerometer in the Y-axis direction with a preset threshold value; if both a absolute value of the acceleration component measured by the first accelerometer and a absolute value of the acceleration component measured by the second accelerometer are greater than the preset threshold value, determining that the folding shaft is perpendicular to a horizontal plane, thereby determining that the first accelerometer and the second accelerometer are failed.

18. The method of claim 17, wherein the "if the first accelerometer and the second accelerometer are not failed, then calculating the bending angle of the electronic device, based on the accelerations measured by the first accelerometer and the second accelerometer" comprises: according to the acceleration components measured by the first accelerometer and the second accelerometer, calculating the bending angle of the electronic device by using a following formula:

$$\gamma = \left| \arccos\left(\frac{z2}{\sqrt{x2^2+y2^2+z2^2}}\right) - \arccos\left(\frac{z1}{\sqrt{x1^2+y1^2+z1^2}}\right) \right| \; ;$$

wherein $\gamma$ represents the bending angle of the electronic device, x1, y1, z1 each represents a corresponding acceleration component in the X-axis direction, the Y-axis direction, and the Z-axis direction measured by the first accelerometer, x2, y2, z2 each represents a corresponding acceleration component in the X-axis direction, the Y-axis direction, and the Z-axis direction measured by the second accelerometer.

19. The method of claim 17, wherein the "if the first accelerometer and the second accelerometer are not failed, then calculating the bending angle of the electronic device, based on the accelerations measured by the first accelerometer and the second accelerometer", comprises: according to the acceleration components measured by the first accelerometer and the second accelerometer, calculating the bending angle of the electronic device by using a following formula:

$$\gamma = \left| \arccos(z2/g) - \arccos(z1/g) \right| \; ;$$

wherein $\gamma$ represents the bending angle of the electronic device, z1 represents the acceleration component in the Z-axis direction measured by the first accelerometer, z2 represents the acceleration component in the Z-axis direction measured by the second accelerometer, and g represents gravitational acceleration.

20. The method of claim 17, wherein the "if the first accelerometer and the second accelerometer being failed, then calculating the bending angle of the electronic device, based on the magnetic induction intensity measured by the first magnetometer and the second magnetometer", comprises: the first magnetometer and the second magnetometer are configured for detecting magnetic induction intensity components in specified directions, the specified directions comprise an X-axis direction, a Y-axis direction, and a Z-axis direction;
if the first accelerometer and the second accelerometer being failed, according to the magnetic induction intensity components measured by the first magnetometer in the X-axis direction, the Y-axis direction and the Z-axis direction, and the magnetic induction intensity components measured by the second magnetometer in the X-axis direction, the Y-axis direction, and the Z-axis direction, calculating the bending angle of the electronic device by using a following formula:

$$\gamma = \left| \arccos\left(\frac{z4}{\sqrt{x4^2+y4^2+z4^2}}\right) - \arccos\left(\frac{z3}{\sqrt{x3^2+y3^2+z3^2}}\right) \right| \; ;$$

wherein $\gamma$ represents the bending angle of the electronic device, x3, y3, z3 each represents a corresponding magnetic induction intensity component in the X-axis direction, the Y-axis direction and the Z-axis direction measured by the first magnetometer, x4, y4, z4 each represents a corresponding magnetic induction intensity component in the X-axis direction, the Y-axis direction, and the Z-axis direction measured by the second magnetometer.

FIG. 1

FIG. 2

115

113

z2

a2

115

113

γ

β

α

a1

z1

Horizontal plane

FIG. 3

| accelerations measured by the accelerometers of the at least two measuring components or magnetic induction intensity measured by the magnetometers of the at least two measuring components are obtained | 401 |

| the bending angle of the electronic device is calculated based on the accelerations measured by the accelerometers of the at least two measuring components or the magnetic induction intensity measured by the magnetometers of the at least two measuring components | 403 |

FIG. 4

Accelerations measured by the first accelerometer and the second accelerometer are obtained ⌐ 501

Whether the first accelerometer and the second accelerometer are failed is determined. ⌐ 502

YES

NO

The bending angle of the electronic device is calculated, based on the acceleration component measured by the first accelerometer and the second accelerometer. ⌐ 503

The first magnetometer and the second magnetometer are started to measure the magnetic induction intensity ⌐ 504

The bending angle of the electronic device is calculated, based on the magnetic induction intensity measured by the first magnetometer and the second magnetometer ⌐ 505

FIG. 5

## INTERNATIONAL SEARCH REPORT

| International application No. |
|---|
| **PCT/CN2018/101098** |

**A. CLASSIFICATION OF SUBJECT MATTER**

G01B 21/22(2006.01)i; G06F 1/16(2006.01)i

According to International Patent Classification (IPC) or to both national classification and IPC

**B. FIELDS SEARCHED**

Minimum documentation searched (classification system followed by classification symbols)

G01B; G06F

Documentation searched other than minimum documentation to the extent that such documents are included in the fields searched

Electronic data base consulted during the international search (name of data base and, where practicable, search terms used)

CNPAT, CNKI, WPI, EPODOC: 弯曲, 折叠, 角度, 柔性, 显示, 加速度, 磁力, bending, fold, angle, flexible, display, acceler +, magnet+

**C. DOCUMENTS CONSIDERED TO BE RELEVANT**

| Category* | Citation of document, with indication, where appropriate, of the relevant passages | Relevant to claim No. |
|---|---|---|
| X | US 2017016720 A1 (SAMSUNG DISPLAY CO., LTD.) 19 January 2017 (2017-01-19) description, paragraphs [0026]-[0050], and figures 1 and 3 | 1-2, 11-15 |
| X | CN 107656682 A (BEIJING XIAOMI MOBILE SOFTWARE CO., LTD.) 02 February 2018 (2018-02-02) description, paragraphs [0054]-[0141] | 1-2, 11-15 |
| A | CN 104685448 A (SAMSUNG ELECTRONICS CO., LTD.) 03 June 2015 (2015-06-03) entire document | 1-20 |

☐ Further documents are listed in the continuation of Box C.   ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **06 May 2019** | **15 May 2019** |

| Name and mailing address of the ISA/CN | Authorized officer |
|---|---|
| **State Intellectual Property Office of the P. R. China** **No. 6, Xitucheng Road, Jimenqiao Haidian District, Beijing 100088** **China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2018/101098**

| Patent document cited in search report | | | Publication date (day/month/year) | Patent family member(s) | | | Publication date (day/month/year) |
|---|---|---|---|---|---|---|---|
| US | 2017016720 | A1 | 19 January 2017 | EP | 2757439 | A1 | 23 July 2014 |
| | | | | KR | 20140094333 | A | 30 July 2014 |
| | | | | US | 2014202014 | A1 | 24 July 2014 |
| CN | 107656682 | A | 02 February 2018 | US | 2018031370 | A1 | 01 February 2018 |
| | | | | EP | 3276301 | A1 | 31 January 2018 |
| CN | 104685448 | A | 03 June 2015 | KR | 20140016073 | A | 07 February 2014 |
| | | | | WO | 2014021616 | A1 | 06 February 2014 |
| | | | | RU | 2015106678 | A | 27 September 2016 |
| | | | | EP | 2880512 | A1 | 10 June 2015 |
| | | | | US | 2014029017 | A1 | 30 January 2014 |
| | | | | IN | 201501396 | P1 | 03 July 2015 |

Form PCT/ISA/210 (patent family annex) (January 2015)